# EUROPEAN PATENT APPLICATION

(11) **EP 1 458 015 A2**
(43) Date of publication of application: **15.09.2004**
(21) Application number: 04251412.5
(22) Date of filing: 11.03.2004
(51) Int. Cl.: H01L 21/00

(54) **Spin coating apparatus for coating photoresist**

(30) Priority: 11.03.2003 KR 2003015154
(71) Applicant: Samsung Electronics Co., Ltd., Suwon-si, Gyeonggi-do (KR)
(72) Inventor: Lee, Eun-sung, Joong-gu Daejeon (KR); Choa, Sung-hoon, Seodaemun-gu Seoul (KR); Choi, Min-seog, Songpa-gu Seoul (KR)
(74) Representative: Ertl, Nicholas Justin

(57) **Abstract**

A spin coating apparatus for coating photoresist has a spin chuck and a nozzle part. The spin chuck has a mount part on which a wafer is mounted and an extended projection part on which edge-bead is formed. The nozzle part is for depositing photoresist onto the wafer mounted on the mount part of the spin chuck. By using the spin coating apparatus, edge-bead is formed on the extended projection part, and not on the wafer.

## Description

An apparatus consistent with the present invention relates to coating photoresist on a wafer and, more particularly, to a spin coating apparatus, for coating photoresist, that comprises a spin chuck provided with an extended projection so that an edge-bead is formed on the extended proj ection, and not on a wafer.

Photoresist coating methods applied in the photoresist coating process include spin coating, spray coating and the like. Among them, the spin coating is most widely used.

The spin coating is performed by depositing photoresist at the center of a wafer mounted on a spin chuck, and rotating the spin chuck so that the deposited photoresist is evenly spread on the wafer.

However, in the photoresist coating process that utilizes spin coating, an edge-bead forms at the edge of the wafer due to self-stress of the photoresist and stress between the photoresist and the wafer. The edge-bead may cause irregular development of photoresist. Also, in case of performing contact alignment, the edge-bead may adhere to a mask, hindering an alignment.

In order to solve the above-described problems, the coating of photoresist is followed by a process to remove the edge-bead. The process for removal, of the edge-bead, or so-called EBR (Edge-Bead Removal) process is carried out by spraying a solvent, which is capable of dissolving the photoresist, at the edge of the wafer where the edge-bead is formed.

However, the EBR process may remove a photoresist layer as well as the edge-bead at the edge of the wafer. As a result, the usable area of the wafer is reduced. For example, in case of a 4-inch wafer, the unusable area resulting from the edge-bead formation has approximately a 1 cm width from the outermost comer edge toward the inside center. Therefore, the usable area of the wafer after EBR is only 64% of the whole area of the wafer. Hence, about 36% of the wafer area cannot be used.

Further, the EBR may increase the cost needed for the manufacturing process of wafers.

Korean Patent Application No. 2000-0046000 discloses a spin coating apparatus, which enables both the process for coating photoresist on a wafer and the EBR.

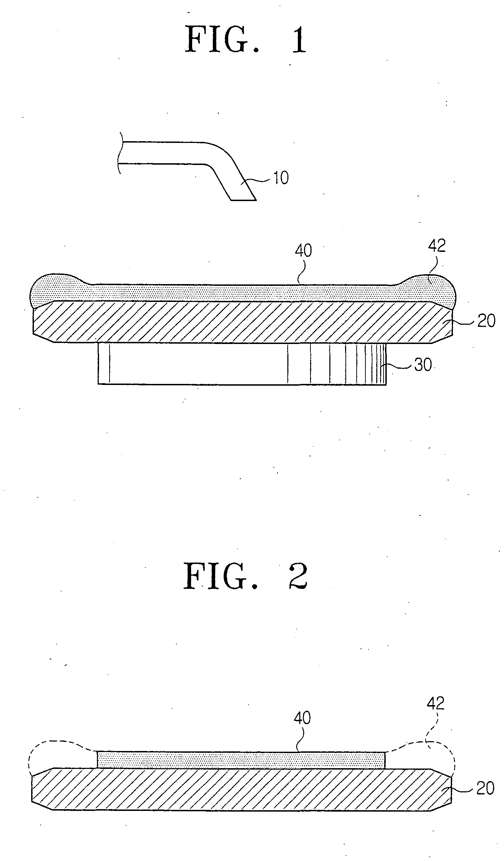

FIG. 1 is a view schematically showing a cross-section of a conventional spin coating apparatus for coating photoresist, and FIG. 2 is a view schematically showing a cross-section of a wafer having photoresist applied thereon, after the EBR.

Referring to FIG. 1 and FIG. 2, a wafer 20 is mounted on a spin chuck 30 which has a diameter greater than that of the wafer 20. On the wafer 20, photoresist is applied to form a photoresist layer 40. At the edge of the wafer 20, edge-bead 42 is formed due to excessive application of photoresist. A nozzle part 10 is provided at a predetermined distance upward from the wafer 20 to deposit photoresist at the center of the wafer 20.

The process for coating photoresist on a wafer using the spin coating apparatus for coating photoresist will be described in detail as follows.

Photoresist is deposited on the center of the wafer 20 through the nozzle part 10. The spin chuck 30 is rotated to evenly apply the deposited photoresist on the whole area of the wafer 20. The photoresist is evenly spread on the whole area of the wafer 20 by the centrifugal force due to the rotation. However, at the edge of the wafer 20, the photoresist is excessively applied due to the self-stress of the photoresist and the stress between the photoresist and the wafer 20, thereby forming the edge-bead 42. Then, the EBR process to remove the edge bead is performed by spraying an agent capable of dissolving the photoresist at the edge of the wafer through a dissolvent nozzle part.

The EBR process may remove the edge bead 42, however, the photoresist layer at the edge of the wafer 20 disappears, as shown in FIG. 2. Therefore, the usable area of the wafer is reduced. Further, there is a problem related to the incurrence of a cost for the EBR.

An apparatus consistent with the present invention provides a spin coating apparatus for coating photoresist, which has a spin chuck in which an edge-bead is formed on an extended projection instead of a wafer, and a gas exhaust part for preventing by gas exhaustion the edge-bead from forming on the wafer, and therefore improves reliability of the wafer.

In accordance with an exemplary embodiment of the present invention, the above and other aspects and/or features can be accomplished by the provision of a spin coating apparatus for coating photoresist comprising a spin chuck having a mount part on which a wafer is mounted and an extended projection part on which edge-bead is formed. A nozzle part is provided for depositing photoresist onto the wafer, which is mounted on the mount part of the spin chuck.

According to another aspect of the present invention, the extended projection part of the spin chuck has a height equal to, or lower than, that of the wafer mounted on the mount part.

Also, the extended projection part of the spin chuck may be formed to surround the circumference of the wafer while being in contact with the circumference of the wafer mounted on the mount part.

Meanwhile, the spin chuck may further comprise a separation part for separating the wafer from the spin chuck.

Further, the spin coating apparatus for coating photoresist may further comprise a gas exhaust part disposed so that gas is exhausted from the edge of the wafer in the turning direction of the wafer and the centrifugal direction upon rotation of the wafer.

Thus, the spin coating apparatus for coating photoresist according to an aspect of the present invention comprises a spin chuck for rotating a wafer, a nozzle part for depositing photoresist onto the wafer mounted on the spin chuck and a gas exhaust part disposed so that gas is exhausted from the edge of the wafer in the turning direction of the wafer and the centrifugal direction upon rotation of the wafer.

The above and other objects, features and advantages of the present invention will be become more apparent by describing in detail exemplary embodiments thereof with reference to the accompanying drawings, in which:
FIG. 1 is a schematic cross-sectional view of a conventional spin coating apparatus for coating photoresist;
FIG. 2 is a schematic cross-sectional view of a wafer having a photoresist layer formed thereon, after the EBR according to a related art;
FIG 3 is a schematic cross-sectional view of a spin coating apparatus for coating photoresist according to the present invention;
FIG. 4 is a view explaining the separation of a wafer from a spin chuck provided with a separation part;
FIG. 5 is a schematic cross-sectional view of a spin coating apparatus for coating photoresist according to the present invention which further comprises a gas exhaust part;
FIG. 6 is a schematic cross-sectional view of a wafer on which a photoresist layer is formed using the spin coating apparatus for coating photoresist shown in FIG. 5; and
FIG. 7 is a schematic cross-sectional view of a spin coating apparatus for coating photoresist according to the present invention which further comprises a gas exhaust part.

The present invention will now be described more fully with reference to the accompanying drawings, in which illustrative, non-limiting embodiments of the invention are shown. In the drawings, like reference numbers refer to like elements throughout, and the sizes of elements may be exaggerated for clarity.

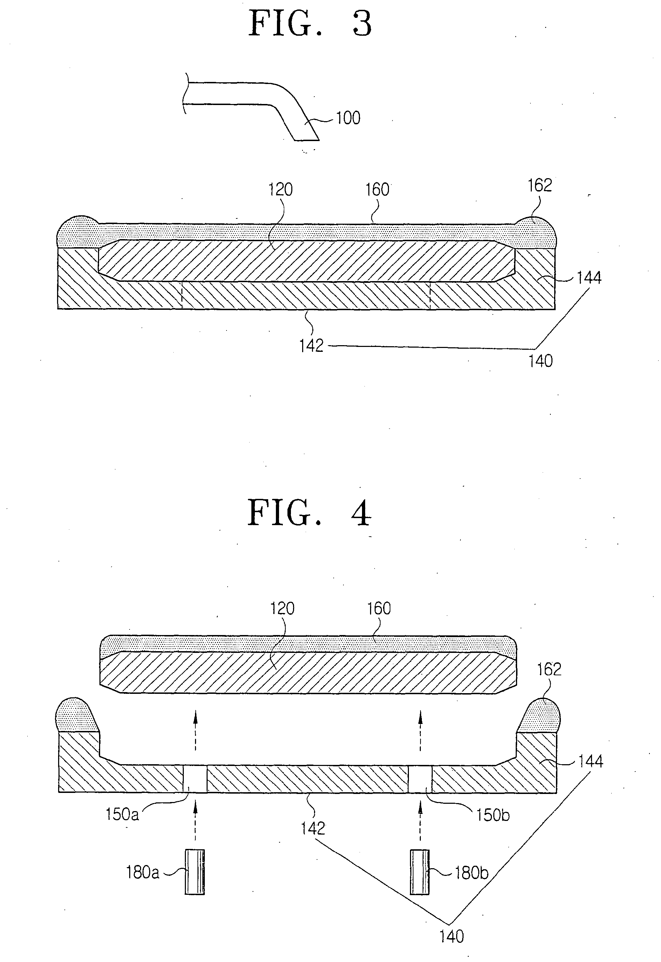

FIG 3 is a schematic cross-sectional view of a spin coating apparatus for coating photoresist according to the present invention.

As shown in FIG. 3, a spin chuck 140 includes a mount part 142 on which a wafer 120 is mounted and an extended projection part 144 on which an edge-bead is formed. A nozzle part 100 is provided at a predetermined distance upward from the wafer 120 to deposit photoresist on the wafer 120.

The mount part 142 has the same shape as a conventional spin chuck.

The extended projection part 144 is extended to a predetermined distance from the mount part 142 and then projected upward. The extended projection part 144 is formed to have a height that is not higher, but lower than that of the wafer 120 mounted on the mount part 142 of the spin chuck 140. If the extended projection part 144 has a height higher than that of the wafer 120 mounted on the mount part 142, the photoresist spread by the centrifugal force cannot further progress due to the extended projection part 144 but is gathered in front of the extended projection part 144. As a result, the edge-bead is still formed on the wafer 120.

In FIG. 3, the extended projection part 144 is shown to have a height that is lower than that of the wafer 120 mounted on the mount part 142, however, the extended projection part 144 may have a height equal to that of the wafer 120 mounted on the mount part 142.

The extended projection part 144 is formed to surround the circumference of the wafer 120 while being in contact with the circumference of the wafer 120 mounted on the mount part 142. This is because the photoresist spread by the rotation of the spin chuck may escape between the extended projection part 144 and the wafer 120 to form edge-bead on the wafer 120 when the extended projection part 144 is not in contact with the circumference of the wafer 120.

As shown in FIG. 3, the edge-bead 162 is formed on the extended projection part 144, not on the wafer 120. Preferably, the extended projection part 144 has a width at its upper part greater than or equal to that of the unusable area of the wafer defined by the edge-bead 162.

FIG 4 is a view explaining the separation of a wafer from a spin chuck provided with a separation part.

After forming a photoresist layer 160, in order to more easily separate the wafer 120 from the spin chuck 140, the spin chuck 140 is provided at its lower surface with separation parts 150a, 150b. The separation of the wafer 120 from the spin chuck 140 is performed by inserting separation members 180a, 180b into the separation parts 150a, 150b to push the bottom of the wafer 120. By this, the wafer 120 can be readily separated from the spin chuck 140 without damage of the photoresist layer 160 formed on the wafer 120.

Meanwhile, though two separation parts 150a, 150b are shown in FIG. 4, two or more separation parts can be utilized.

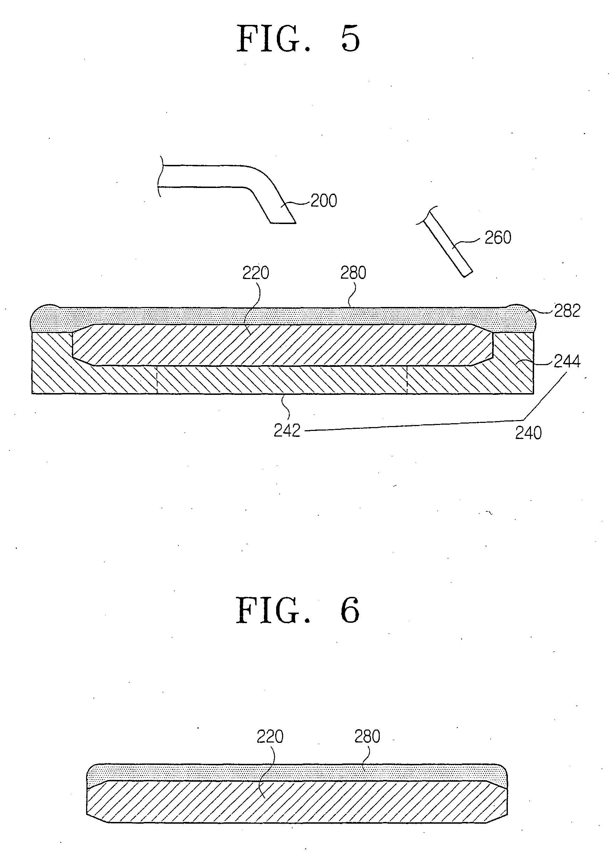

FIG. 5 is a schematic cross-sectional view of a spin coating apparatus for coating photoresist according to the present invention which further comprises a gas exhaust part.

When photoresist is coated using the spin coating apparatus shown in FIG. 3, the edge-bead is formed on the extended projection part. However, if an excessive amount of photoresist is applied on the extended projection part, a little edge-bead can be formed at the edge of the wafer.

Therefore, in order to prevent an edge-bead 282 from forming on a wafer 220, 1 and only forming on an extended projection part 244, it is preferable to use a spin coating apparatus for coating photoresist which further comprises a gas exhaust part 260 disposed so that gas is exhausted from the edge of the wafer in the turning direction of the wafer and the centrifugal direction upon rotation of the wafer.

As shown in FIG. 5, the wafer 220 is mounted on a mount part 242 of a spin chuck 240. The mounted wafer 220 has a height higher than that of the extended projection part 244, as explained with reference to FIG. 3. A nozzle part 200 is disposed at a predetermined distance from the wafer 220 to deposit photoresist at the center of the wafer 220. Also, the gas exhaust part 260 is disposed at a predetermined place so that gas is exhausted from the edge of the wafer in the turning direction of the wafer and the centrifugal direction upon rotation of the wafer.

The application of the above described spin coating apparatus for coating photoresist is described as follows.

The wafer 220 is mounted on the mount part 242 of the spin chuck 240 and photoresist is deposited at the center of the wafer 220 through the nozzle part 200. Then, the spin chuck 240 is rotated to evenly spread a photoresist layer 280 on the wafer 220 and the extended projection part 244.

Meanwhile, while the photoresist is applied on the wafer 220 and the extended projection part 244, gas is exhausted over the wafer 220 through the gas exhaust part 260. Here, the gas is exhausted in the turning direction of the wafer 220 and the centrifugal direction upon rotation of the wafer and also exhausted from the edge of the wafer 220, that is, from the area where the wafer 220 comes in contact with the extended projection part 244. If the gas exhaust direction is reverse to the turning direction of the wafer 220 and the centrifugal direction, or the gas is exhausted from any other region than the region where the wafer 220 comes in contact with the extended projection part 244, the edge-bead 282 may be formed on other regions than the extended projection part 244.

FIG. 6 shows a schematic cross-sectional view of a wafer 220 on which a photoresist layer 280 is formed by the above procedures. There is no edge-bead formed at the edge of the wafer 220. Therefore, the wafer 220 shown in FIG. 6 has a usable area substantially equal to the whole area of the wafer.

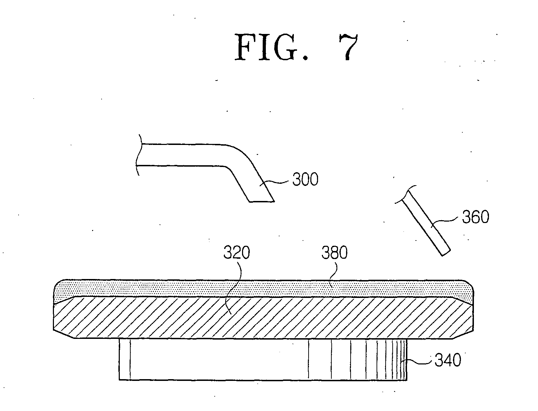

FIG. 7 is a schematic cross-sectional view of a spin coating apparatus for coating photoresist according to the present invention which further comprises a gas exhaust part.

When photoresist is coated using the spin coating apparatus shown in FIG. 3 or FIG. 5, little edge-bead is formed on the wafer.

However, it is possible to prevent edge-bead from forming on the wafer 320 without the spin chuck as shown in FIG. 3 and FIG. 5. In other words, the edge-bead formation on the wafer 320 can also be prevented by using a spin coating apparatus, which has a conventional spin chuck 340, a nozzle part 300 for depositing a photoresist layer 380 onto the wafer 320 mounted on the spin chuck 340, and a gas exhaust part 360 disposed so that gas is exhausted from the edge of the wafer 320 in the turning direction of the wafer 320 and the centrifugal direction upon rotation of the wafer 320.

As shown in FIG. 7, edge-bead is not formed on the wafer 320. Therefore, the EBR is unnecessary and the usable area of the wafer is maximized, whereby the reliability of the wafer is improved.

According to the present invention, by using a spin coating apparatus for coating photoresist comprising a spin chuck having a mount part on which a wafer is mounted and an extended projection part on which an edge-bead is formed, and a nozzle for depositing photoresist onto the wafer mounted on the mount part of the spin chuck, photoresist can be applied without forming edge-bead on the wafer. As a result, the EBR procedure is not needed, whereby it is possible to obtain the effect to cut down the manufacturing cost of the wafer.

Also, since the usable. area of the wafer is not reduced even when the EBR procedure is omitted, the reliability of the wafer can be improved.

Meanwhile, it is possible to obtain the above-described effect by using a spin coating apparatus for coating photoresist comprising a gas exhaust part disposed so that gas is exhausted from the edge of the wafer in the turning direction of the wafer and the centrifugal direction upon rotation of the wafer, without the spin chuck as described above.

Although exemplary embodiments of the present invention have been disclosed for illustrative purposes, those of ordinary skill in the art will appreciate that the present invention is not limited to the particular embodiments described above but various changes, modifications and variations can be made, without departing from the scope of the invention as claimed in the accompanying claims and such changes fall within the scope of the following claims.

## Claims

1. A spin chuck for a spin coating apparatus that coats photoresist onto a wafer, the spin chuck comprising:
a mount part adapted to mount the wafer thereon; and
an extended projection part, extending from the mount part, for facilitating formation of an edge-bead thereon.

2. The spin chuck according to claim 1, wherein the extended projection part has a height lower than the combined height of the mount part and the wafer mounted on the mount part.

3. The spin chuck according to claim 1 or 2, wherein the extended projection part has a height equal to the combined height of the mount part and the wafer mounted on the mount part.

4. The spin chuck according to any one of the preceding claims, wherein the extended projection part is arranged to surround a circumference of the wafer while being in contact with the circumference of the wafer mounted on the mount part.

5. The spin chuck according to any one of the preceding claims, further comprising a separation part for separating the wafer from the spin chuck.

6. A spin coating apparatus for coating photoresist onto a wafer, comprising:
the spin chuck of any one of the preceding claims; and
a nozzle for depositing photoresist onto the wafer mounted on the mount part of the spin chuck.

7. The spin coating apparatus according to claim 6, further comprising a gas exhaust part disposed so that gas is exhausted at an edge of the wafer in a turning direction of the wafer and a centrifugal direction upon rotation of the wafer.

8. A spin coating apparatus for coating photoresist onto a wafer, comprising:
a spin chuck for rotating the wafer;
a nozzle part for depositing photoresist onto the wafer mounted on the spin chuck; and
a gas exhaust part disposed so that gas is exhausted at an edge of the wafer in a turning direction of the wafer and a centrifugal direction upon rotation of the wafer.

9. A method of spin coating photoresist onto a wafer, the method comprising:
mounting the wafer on a spin chuck, the spin chuck comprising a mount part for mounting the wafer thereon and an extended projection part extending from the mount part for facilitating formation of an edge-bead thereon; and
rotating the wafer on the spin chuck and, at the same time, depositing photoresist onto the wafer through a nozzle part, thereby forming an edge-bead on the extended projection part of the spin chuck.

10. A method of spin coating photoresist onto a wafer, the method comprising:
mounting the wafer on a spin chuck; and
rotating the wafer on the spin chuck and, at the same time, depositing photoresist onto the wafer through a nozzle part and exhausting gas through a gas exhaust part at an edge of the wafer in a turning direction of the wafer and a centrifugal direction upon rotation of the wafer.
